# EUROPEAN PATENT APPLICATION

(11) **EP 1 760 802 A2**
(43) Date of publication of application: **07.03.2007**
(21) Application number: 06018477.7
(22) Date of filing: 04.09.2006
(51) Int. Cl.: H01L 51/52, H01L 51/54

(54) **Radiation emitting device and method of manufacturing the same**

(30) Priority: 02.09.2005 EP 05019106; 10.11.2005 EP 05024592
(71) Applicant: Osram Opto Semiconductors GmbH, 93049 Regensburg (DE)
(72) Inventor: Arici Bogner, Elif, 4062 Kirchberg Thening (AT); Gärditz, Christoph, 91052 Erlangen (DE); Heuser, Karsten, 91056 Erlangen (DE); Hunze, Arvid, 91056 Erlangen (DE); Pätzold, Ralph, 91154 Roth (DE)
(74) Representative: Epping - Hermann - Fischer

(57) **Abstract**

In one embodiment the invention provides a radiation emitting electronic device (1) comprising a substrate (5), a radiation emitting functional area (10A, 10B, 15) on the substrate (5) and a radiation out-coupling material (20) comprising polysilsesquioxane (20D) and inorganic nanoparticles (20C) arranged in the optical path (100) of the radiation emitting functional area (10A, 10B, 15). Such a device has a higher luminance due to an increased fraction of out-coupled radiation in comparison to a device having no radiation out-coupling material.

## Description

The publication "Organic light emitting device with an ordered monolayer of silica microspheres as a scattering medium" published in Applied Physics Letters Vol. 76, No. 10 of March 6, 2000 discloses an organic light emitting device "OLED" based on organic thin films having a glass substrate and a monolayer of hexagonally closed packed arrays of silica spheres with a submicrometer size attached to the glass substrate through which the emitted light comes out. The arrays of silica microspheres scatter light which is wave guided within the glass substrate and contribute to an increase in the amount of light emitted towards the viewer.

It is the main object of one embodiment of the invention to provide a radiation emitting electronic device having an increased out-coupling efficiency of the radiation produced by the device. One embodiment of the present invention meets this need by providing a radiation emitting electronic device according to base claim 1. Further embodiments of the invention and methods of manufacturing radiation emitting electronic devices are subject of further dependent and independent claims.

One embodiment of the invention describes a radiation emitting electronic device comprising
- a substrate,
- a radiation emitting functional area on the substrate and
- a radiation out-coupling material comprising polysilsesquioxane and inorganic nanoparticles arranged in the optical path of the radiation emitting functional area.

Due to the radiation out-coupling material such a device has a higher external radiation efficiency compared to a similar device which lacks such a radiation out-coupling material. The inorganic nanoparticles can form inter alia scattering centres in the radiation out-coupling material thereby leading to an increased fraction of out-coupled radiation in this device. The polysilsesquioxane (POSS) material can build up a matrix in which the inorganic nanoparticles are distributed, thereby forming a so-called guest-host-system e.g.(guest = POSS; host = inorganic nanoparticles).

The term polysilsesquioxane denotes polymeric silica-oxygen compounds of the following general formula Si₂ₙR₂ₙO₃ₙ wherein the index n is a non-negative integer and all the substituents R can independently of each other be any substituent for example an inorganic substituent such as hydrogen or organic substituents such as alkyl groups, which potentially can contain further functional groups. The substituents can even contain inorganic atoms such as e. g. Si atoms. The index n can be any number, preferably n = 10-12 for cage-like POSS materials.

In a further embodiment of the invention the radiation out-coupling material is substantially transparent for the emitted radiation of the radiation out-coupling material. The term "substantially transparent" means that the radiation out-coupling material has a transparency of at least 50%, or 70 % for the emitted radiation, preferably greater than 90 % most preferred greater than 95 %. The transparency of the radiation out-coupling material can for example be determined using densitometers or transmission-spectrometers. It is also possible to determine the transparency by measuring the absorption of the sample.

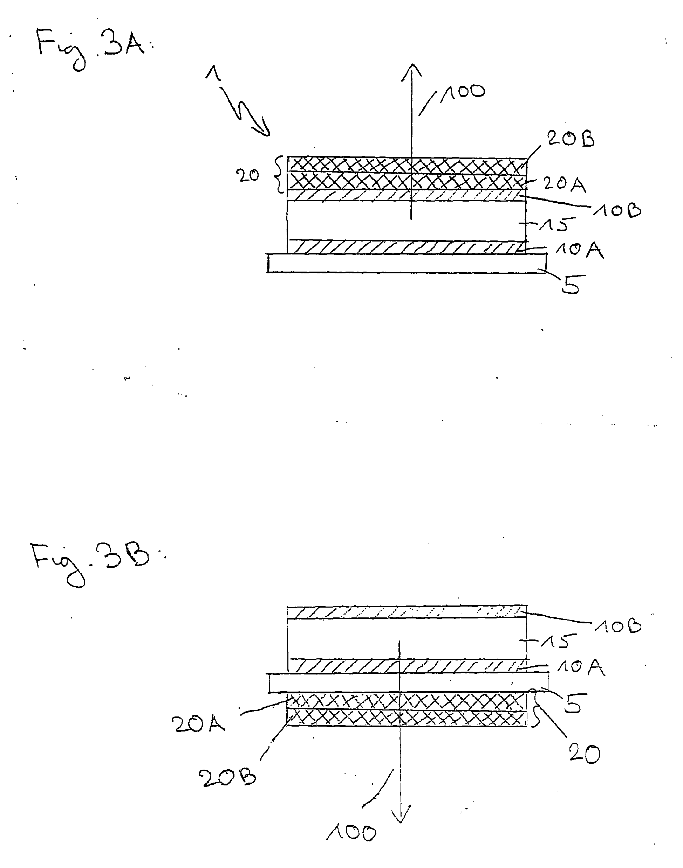

The nanoparticles can have a size of around 100 nm to 1 µm, preferably 200 nm to 500 nm or can even have a size of less than 100 nm in one dimension. Due to their small size the nanoparticles can effectively scatter the radiation generated by the functional area without absorbing too much of the emitted radiation (see for example Fig. 4).

In contrast to other polymeric materials for example polymethylmethacrylate (PMMA) or polycarbonate, polysilsesquioxane has the advantage that it has a higher glass transition temperature Tg and also shows an enhanced durability due to a reduced temperature dependency of the aging of this material.

The polysilsesquioxane matrix with the inorganic nanoparticles can also provide a higher out-coupling of the radiation produced by the electronic device via radiation refraction (see for example Fig. 4).

The polysilsesquioxane of the radiation out-coupling material can be obtainable by reacting molecules of the following general formula: 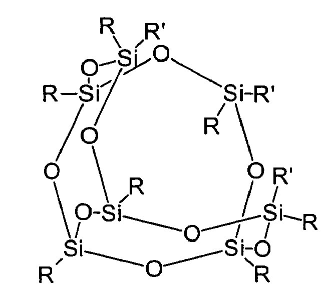 wherein the substituent R is selected from:
- organic epoxides, hydrogen, alkyl-groups, alcohols, alkoxy-groups and ester-groups and
   the substituent R' can be independently of each other a -O-Si (Alkyl)₂-Glycidoxy-alkyl-group with alkyl = C₁ to C₁₂ alkyl groups, so that a molecule of the following general formula might result:

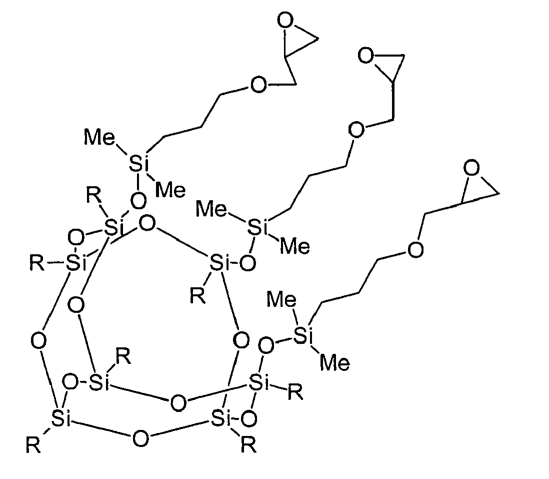

Alternatively the three R' groups can together form a bridging group so that a molecule of the following generals formula results:

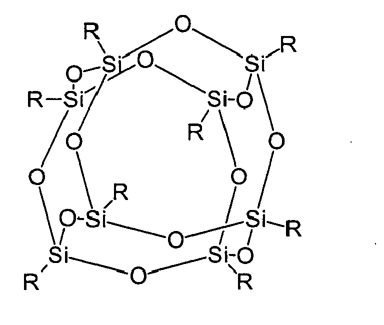

Molecules with the above mentioned general formulae can easily be adopted for different combinations of polysilsesquioxane and inorganic nanoparticles by e. g. varying the substituents R or R' in order to be suitable for different applications. For example organic epoxides as substituent R or R' can be introduced into the above-mentioned molecules in order to generate side chains which are important for the polymerization of these molecules to yield the final polysilsesquioxane. Silsesquioxane monomers with the above-mentioned general formula preferably contain one or two substituents R having functional groups used for polymerization, for example epoxide groups. These groups can be used to incorporate the monomers into a polymeric network. Depending whether the monomers form the endpoints of a polymeric chain or are located within the larger chain, one, two, three or even more of the substituents R can comprise polymerizable groups. Monomers with more than two polymerizable groups can be used to form for example a highly crosslinked network of polysilsesquioxane, thereby also changing the chemical nature of this polymer when compared to a polysilsesquioxane which is not so highly crosslinked.

The substituents R can also comprise unreactive organic groups in order to ensure a good dispersion and compatibilization with the inorganic nanoparticles. The substituents R also enable an adjusting of the viscosity. For example R can be selected from a group consisting of straight or branched alkyl groups, organic epoxides, hydrogen, alcohols, alkoxy-groups and ester-groups. Moreover one or more substituents R can also comprise one or more reactive groups for polymerization, for example co- or homopolymerization. Molecules with such a general formula can easily be incorporated into a thermally and chemically robust hybrid organic/inorganic polysilsesquioxane framework. Polysilsesquioxane material obtainable via reaction of molecules with the above-mentioned general formulae can easily be used as a matrix for the inorganic nanoparticles of the radiation out-coupling material. The silsesquioxane monomers with the above-mentioned formulae and the inorganic nanoparticles are preferably mixed and then polymerised using heat or UV radiation to form the radiation out-coupling material.

In another embodiment of the invention the radiation emitting electronic device can comprise an OLED. An OLED device comprises a functional stack located on a substrate. The functional stack comprises at least one or more organic functional layers sandwiched between two conductive first and second layers. The conductive layers function as electrodes (cathode and anode). When a voltage is applied to the electrodes, charge carriers are injected through these electrodes into the functional layers and upon recombination of the charge carriers visible radiation can be emitted (electroluminescence). The organic functional stack on the substrate can be encapsulated by a cap, which can comprise, for example, glass or ceramic. The radiation emitted by such an OLED device can for example be light in the visible range from about 400 nm to about 800 nm, or can also be light emitted in the infrared or UV range. The first conductive layer can e. g. comprise transparent materials such as indium-tin-oxide ITO, zinc oxide and the second conductive layer can comprise metals such as Ca, Mg, Ba, Ag, Al or a mixture thereof or can also comprise the above mentioned transparent materials of the first conductive layer. The second conductive layer can also comprise thin layers of e. g. LiF or CsF.

In another embodiment of the invention the radiation emitting electronic device can also comprise for example an inorganic light emitting LED, including for example ZnS as a functional material.

In a further embodiment of the invention the radiation out-coupling material can comprise 30 to 70 weight% polysilsesquioxane and 70 to 30 weight% of the inorganic nanoparticles. Within such a weight%-range of polysilsesquioxane and transparent inorganic nanoparticles most of the radiation generated by the radiation emitting electronic device can be coupled out of the device via refraction and scattering and is not back scattered or reflected back into the interior of the device. Preferably the radiation out-coupling material comprises around 30 weight% polysilsesquioxane and around 70 weight% of the inorganic nanoparticles or 50 weight% POSS and 50 weight% inorganic nanoparticles.

The inorganic nanoparticles of the radiation out-coupling material can comprise metal oxide particles, for example they can be selected from titanium dioxide, zinc oxide and indium zinc oxide. These materials are especially well suited to be used as inorganic nanoparticles for scattering radiation emitted from an electronic device. Another advantage of the radiation emitting electronic device of this embodiment of the invention is, that the inorganic nanoparticles used are already in the oxidized form and uniform in size. The composition of the polysilsesquioxane and the inorganic nanoparticles can therefore be well defined and homogeneous. The attractive van der Waals interactions of the polysilsesquioxane matrix can also be adapted to the polarity of the inorganic nanoparticles resulting in similar polarity, so that no phase separation is expected and the conditions for long-term stability are largely given.

In a further embodiment of the invention the radiation out-coupling material comprises a polysilsesquioxane matrix with inorganic nanoparticles dispersed therein, wherein the nanoparticles has a higher refractive index then the polysilsesquioxane matrix. Such a material is especial well suited to allow the scattering of the radiation emitted by the device so that the radiation is out-coupled of the device. In this case the polysilsesquioxane matrix might have a refractive index of about 1.6 and the nanoparticles may have a refractive index of about 1.7 to 2.2, or between 1.6 to 1.7. Preferably the refractive index of the radiation out-coupling material is as high as possible.

The radiation out-coupling material further can be arranged in a layer-wise manner on the radiation emitting functional area. Thus an arrangement can result in a very effective out-coupling effect of the radiation reduced by the functional area.

Furthermore in another embodiment of the invention the substrate of the radiation emitting electronic device is substantially transparent for the emitted radiation and the radiation out-coupling material is arranged preferably in a layer wise manner on one of the main surface areas of the substrate. In this case the radiation emitted by the functional area can effectively be out-coupled out of the device via the transparent substrate.

The substrate can furthermore be selected from:
- glass, metal, polymer silicon and ceramic.

These materials can for example be designed in such a way that they are substantially transparent for the emitted radiation and furthermore can be designed in such a way so that the substrate is not just substantially transparent but also flexible. This can be done for example by using transparent polymers such as in order to form flexible substantially transparent substrates. As mentioned above the term "substantially transparent" means that the substrate is at least 70 to 80 %, preferably more than 90% transparent for the emitted radiation.

In another embodiment of the present invention the radiation emitting electronic device can further comprise a cap encapsulating the radiation emitting functional area. This cap can also be substantially transparent for the emitted radiation and in this case the radiation out-coupling material is preferably arranged between the radiation emitting functional area and the cap in order to enhance the out-coupling efficiency of the radiation emitted through the cap. Such a radiation emitting electronic device with a cap can comprise just a transparent substrate or just a transparent cap or also both a transparent substrate and a transparent cap in order to emit radiation through the substrate and the transparent cap at the same time.

The transparent inorganic nanoparticles can be titanium dioxide nanoparticles. The titanium dioxide is preferably in the rutile modification.

In another embodiment of the invention the radiation out-coupling material comprises a layer with at least a first and a second sub-layer, said sub-layers having different ratios of polysilsesquioxane and inorganic nanoparticles (concentration gradient).

Preferably the ratios of polysilsesquioxane and inorganic nanoparticles in the at least two sub-layers are varied in such a way so that the second sub-layer which is nearer to the outside of the device has a lower refractive index than the first sub-layer which is located nearer to the interior of the device. Such a variation of the refraction indices can advantageously decrease the difference between the refraction indices of the second sub-layer and the refraction index of air (about 1.0) so that the so-called "index jump" can be reduced and the fraction of out-coupled radiation can be increased. It is also possible for the radiation out-coupling material to comprise more than two sub-layers, for example three or four sub-layers having a gradually decreasing refractive index when going from the interior of the device to the exterior. The refractive index of the sub-layers can be varied by changing the ratio of polysilsesquioxane to the inorganic nanoparticles (the more nanoparticles the higher the refractive index).

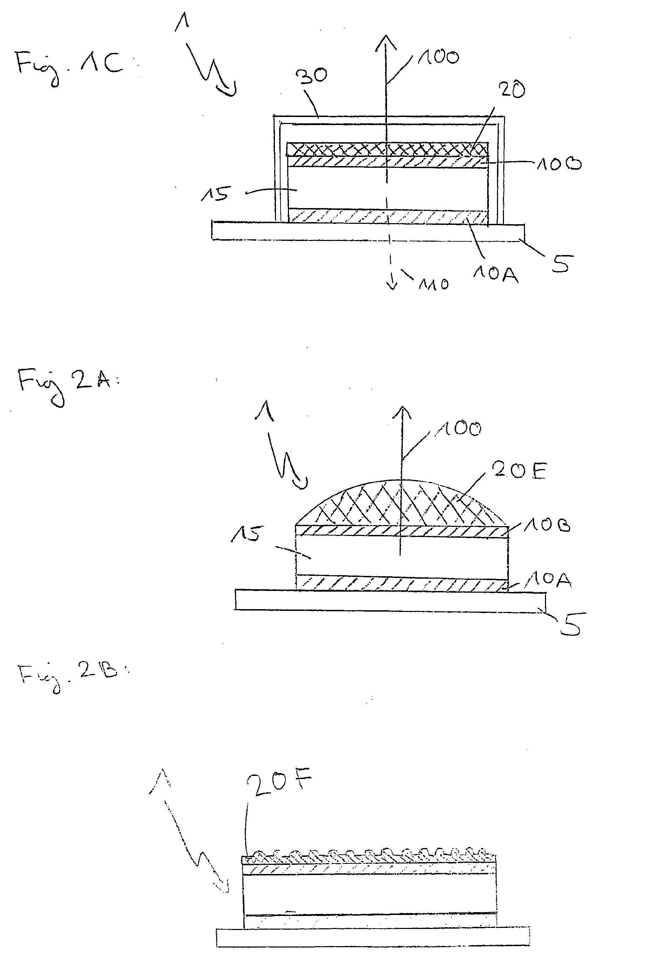

The radiation out-coupling material in one embodiment of the invention can comprise at least one lens. The lens can enhance the intensity of the emitted radiation along the main direction of the emission by focussing the radiation and emitting it along one direction. As shown in figures 2A and 2B the radiation out-coupling material can for example comprise one lens (figure 2A) or can also comprise an array of small microlenses as shown in figure 2B.

In yet another embodiment of the invention phosphors are included in the radiation emitting electronic device. These phosphors are able to convert the radiation emitted by the radiation emitting functional area into radiation with a different wavelength, thereby for example changing the colour of visible light emitted by the radiation emitting electronic device. The phosphors can for example be cerium doped garnets, nitride phosphors, ionic phosphors like SrGa₂S₄:Eu²⁺, SrS:Eu²⁺, fluorescent dyes, quantum dots or conjugated polymers or mixtures thereof. Phosphors can also be used e. g. to downconvert radiation of a short wavelength (for example corresponding to the blue range) to white light of a longer wavelength The output spectrum of the radiation emitting device can then be a combination of unconverted radiation and converted white light.

These phosphors might be arranged in the optical path of the device as a separate layer or might be included in the radiation-outcoupling material. For example the phosphors could be included in the polysilsesquioxane matrix of a separate layer comprising the radiation-outcoupling material, so that this material could function as a radiation-outcoupling layer and also as a radiation conversion layer.

Another embodiment the invention also describes a method of manufacturing a radiation emitting electronic device with the method steps:
A) providing a substrate,
B) producing a radiation emitting functional area on the substrate,
C) providing a radiation out-coupling material comprising polysilsesquioxane and inorganic nanoparticles in the optical path of the functional area.

In a further embodiment of this method of the invention the radiation out-coupling material is formed by polymerizing a blend of silsesquioxane monomers and the inorganic nanoparticles in step C). Preferably a suspension of the monomers and the nanoparticles in a solvent, for example aliphatic or cycloaliphatic solvents such as cyclohexane is polymerized using UV radiation or heat. The temperatures for the polymerization step can be between 100 and 180° C. The suspension of the silsesquioxane monomers and the transparent inorganic nanoparticles is preferably formed on the substrate of the radiation emitting device, by e. g. using wet deposition techniques, for example spin casting or doctor blade techniques. The substrate may be transparent for a bottom-emitting device or may be opaque in the case of a top-emitting device.

In a further embodiment of the method of the invention the radiation out-coupling material can also be formed in the shape of at least one lens. This structuring can be performed by using for example hot embossing, UV embossing methods, spin casting, laser structuring or injection moulding. A substrate, for example a silicon wafer can be structured using photolithographic techniques thereby generating a "negative" form of the lenses to be formed. Subsequently the material for the radiation out-coupling material is applied onto the structured wafer and hardened by e. g. polymerisation, thereby forming the at least one lens.

In the following some embodiments of the invention will be explained in more detail by figures and embodiments. All figures are just simplified schematic representations presented for illustration purposes only.

Figures 1A to 1C show different embodiments of a radiation emitting electronic device formed as an OLED.

Figures 2A to 2D show different embodiments of an OLED with a radiation out-coupling material comprising one lens or an array of microlenses.

Figures 3A and 3B depict another embodiments of the invention wherein the radiation out-coupling material comprises two sub-layers.

Figure 4 is a schematic representation showing one possible mode of action of the out-coupling material.

Figure 5 is a graph showing the differences in the out-coupled light between an OLED according to one embodiment of the invention and a conventional OLED.

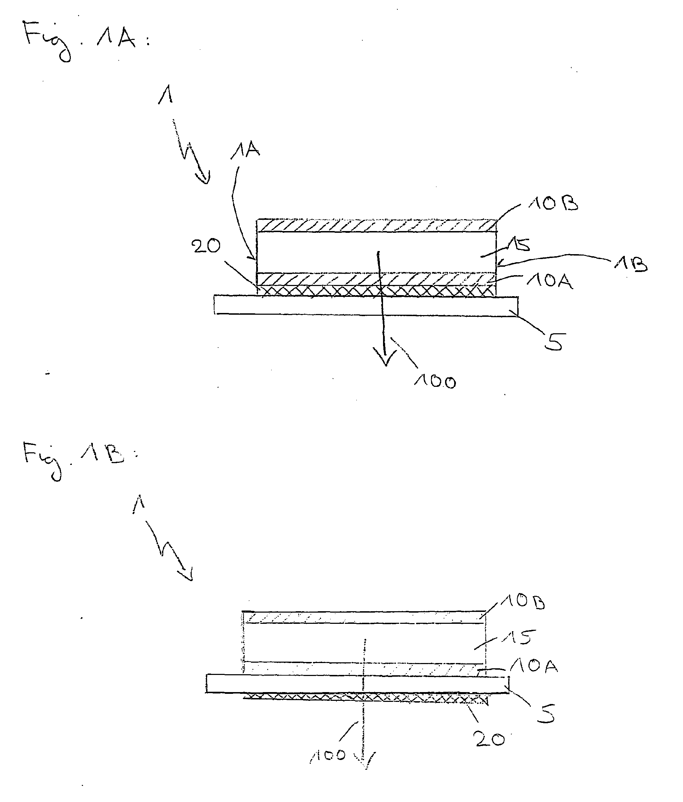

Figure 1A shows a cross-sectional view of a radiation emitting electronic device 1 according to one embodiment of the invention. The radiation emitting device 1 is formed e.g. as an organic light emitting diode (OLED). A functional stack of a first electrode 10A, at least one organic functional layer 15 on the first electrode 10A and a second electrode 10B is arranged on a transparent substrate 5, which is formed of a transparent material for example glass or transparent polymer. In-between the first electrode 10A and the substrate 5 a radiation out-coupling material layer 20 is formed, which enhances the fraction of out-coupled light produced in the organic functional layer 15. The main direction of emission of light is indicated by an arrow marked with the reference number 100. The radiation out-coupling material layer 20 is arranged in the main direction of the emitted light i. e. in the optical path of the light emitting organic functional area 15. In the case that such an OLED also emits light through its side faces 1A, 1B or through its second electrode 10B, additional radiation out-coupling material layers 20 can also be formed on the side faces or the second electrode.

Figure 1B depicts a cross-sectional view of an other organic electronic device 1 according to an other embodiment of the invention. In contrast to the electronic device of figure 1A the radiation out-coupling material is arranged in the form of a layer 20 on the main surface area of the substrate 5 opposite to the functional stack 10A, 15, 10B. In this case the amount of out-coupled light from the OLED 1 can also be enhanced.

Figure 1C shows another embodiment of the invention. In this case an additional transparent encapsulation 30 is formed over the functional stack 10A, 15, 10B. This encapsulation is formed by using a transparent material for example glass or polymer so that the light generated by the functional stack can be emitted through this encapsulation 30, which also may be a thin film encapsulation. A radiation out-coupling layer 20 is arranged between the encapsulation 30 and the second electrode 10B in the optical path 100 indicating the main direction of the emission of the generated light. It is also possible that the OLED device of figure 1C is not just a top-emitting but also a bottom-emitting device, as indicated by the dashed arrow 110. In this case an additional radiation out-coupling material layer 20 may be present as shown in Fig. 1A or 1B.

Figure 2A shows an OLED device 1 having a lens 20A comprising the radiation out-coupling material 20. In contrast to the layers 20 shown in the figures 1A to 1C this lens is also able to focus the intensity of the emitted radiation in the emission direction in the optical path 100 of the OLED device 1.

Figure 2B depicts another cross-sectional view of an OLED device 1 according to another embodiment of the invention. In contrast to figure 2A not one big lens 20A but a microarry 20F of a lot of microlenses is formed from the radiation out-coupling material. A layer 20F formed in such a manner can also focus the out-coupled light and increases the fraction of out-coupled light. Devices with such a microarray of lenses are easier for encapsulation, can be used for flexible LEDs and are still thin compared to an LED with one big microlense. This array of microlenses can also form a so called surface-relief diffractive optical element (DOE).

Figures 2C and 2D show the devices of Figures 2A and 2B respectively, where the big lense 20A and the microarray of lenses 20F are both arranged on the substrate 5 instead of the second electrode 10B of the functional stack. The devices of the Figures 2C and 2D are both bottom-emitting devices, whereas the devices of the Figures 2A and 2B are top-emitting devices. Radiation-emitting devices of another embodiment of the invention can also be both, top- and bottom-emitting devices.

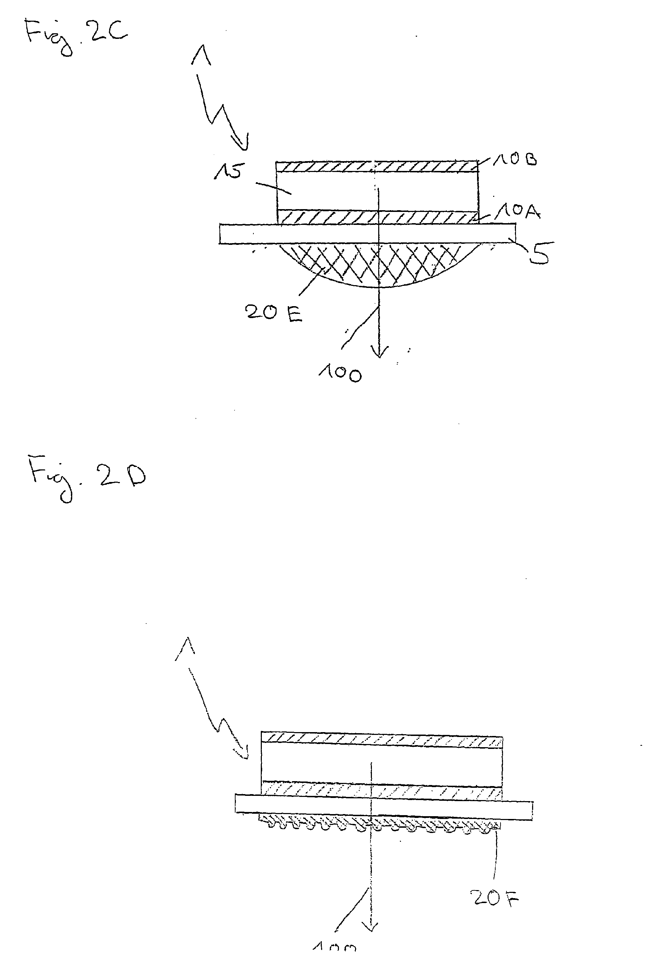

Figure 3A shows in cross-sectional view an organic radiation emitting device 1 according to another embodiment of the invention. In this case the radiation out-coupling layer 20 comprises two sub-layers 20A and 20B. As mentioned above both sub-layers 20A and 20B can have a different refractive index, the refractive index decreasing from layer 20A to 20B thereby increasing the fraction of out-coupled light. Such a layer 20 including the sub-layers can easily be formed by depositing thin sub-layers having different ratios of polysilsesquioxane and for example titanium dioxide particles as transparent inorganic nanoparticles.

Figure 3B depicts a bottom-emitting device wherein the radiation out-coupling layer 20 comprising two sub-layers 20A and 20B is arranged on the substrate 5.

Figure 4 shows in cross-sectional view one possible mode of action of the radiation out-coupling layer 20. This layer 20 comprises a polysilsesquioxane matrix 20D with uniformly dispersed inorganic transparent nanoparticles 20C such as e.g. titanium dioxide particles. These titanium dioxide particles have a higher refractive index than the polysilsesquioxane matrix 20D. The nanoparticles 20C can act a scattering centres, scattering light denoted by the arrow 210 emitted from the emitter 25 which otherwise would be trapped in the device due to reflection. Apart from that the radiation out-coupling layer 20 also out-couples light via refraction as shown with by the arrow denoted with the reference number 200.

In all embodiments shown in figures 1 to 4 the transparent inorganic nanoparticles are titanium dioxide particles.

### Embodiment

A dispersion containing 70 weight % titanium dioxide particles (particles size 300 nm) and 30 weight % tris-glycidylisopropyl-silsesquioxane monomers of the following formula: 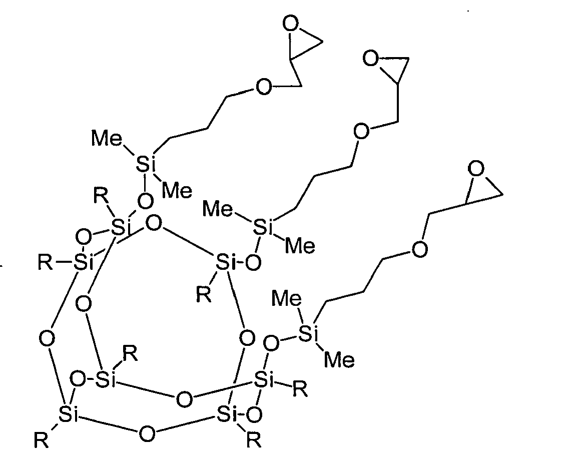 With R = iso-butyl in cyclohexane (10 weight% of the full mass in solution) was applied via spin coating on the transparent substrate of an OLED device. Subsequently the film was dried at room temperature for half an hour using vacuum for five minutes and furthermore polymerized under argon atmosphere at 240°.

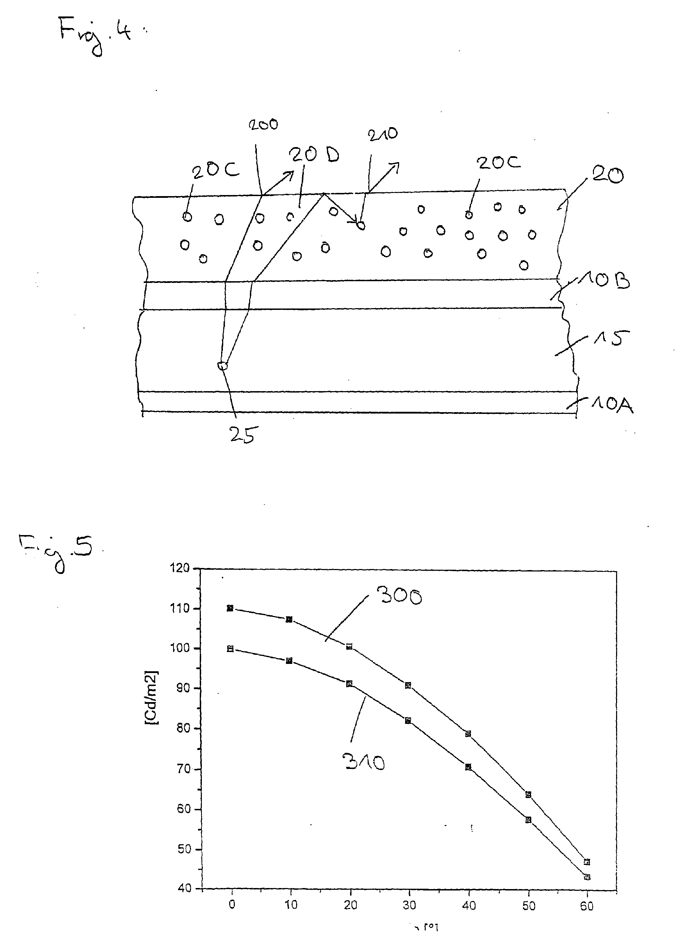

The luminance of this OLED device was compared to the luminance of a conventional OLED device having no radiation out-coupling material. The result of this comparison is shown in the graph in Figure 5. The x-axis denotes the viewing angle in degree [°] and the y-axis denotes the luminance in [Cd/m²]. The curve marked with the reference number 300 shows the luminance of an OLED device with a radiation out-coupling area according to the invention and the curve with the reference numeral 310 shows the same luminance of a conventional OLED device having no radiation out-coupling layer. It can clearly be seen that the radiation out-coupling layer enhances the luminance of the OLED device (10% enhancement at 0°C).

The invention is not limited to the examples given hereinabove. The invention is embodied in each novel characteristic and each combination of characteristics, which particularly includes every combination of any feature which are stated in the claims, even if this feature or this combination of features is not explicitly stated in the claims or in the examples. Variations of the invention are for example possible regarding the composition and the size of the inorganic nanoparticles, the shape of the radiation out-coupling material and the substrate and the layer setup.

## Claims

1. Radiation emitting electronic device (1) comprising:
- a substrate (5),
- a radiation emitting functional area (10A, 10B, 15) on the substrate (5) and
- a radiation out-coupling material (20) comprising polysilsesquioxane (20D) and inorganic nanoparticles (20C) arranged in the optical path (100) of the radiation emitting functional area (10A, 10B, 15).

2. Device (1) according to the previous claim,
- wherein the material (20) comprises 30 to 70 weight% polysilsesquioxane (20D) and 70 to 30 weight% of the inorganic nanoparticles (20C).

3. Device (1) according to one of the previous claims,
- wherein the inorganic nanoparticles (20C) comprise metal oxide particles.

4. Device according to one of the previous claims,
- wherein the inorganic nanoparticles (20C) are selected from a group consisting of : titanium dioxide, zinc oxide and indium zinc oxide.

5. Device according to one of the previous claims,
- wherein the material (20) is arranged in a layer-wise manner on the radiation emitting functional area (10A, 10B, 15).

6. Device according to one of the previous claims,
- wherein the material (20) comprises a polysilsesquioxane matrix (20D) with inorganic nanoparticles (20C) dispersed therein, the nanoparticles having a higher refractive index than the polysilsesquioxane matrix.

7. Device according to the previous claim,
- wherein the polysilsesquioxane matrix (20D) has a refractive index of about 1.6 and the nanoparticles (20C) have a refractive index of about 1.7 to 1.8.

8. Device according to one of the previous claims formed as an OLED,
- wherein the functional area (10A, 10B, 15) comprises a stack of a first electrode (10A), at least one organic functional layer (15) on the first electrode (10A) and a second electrode (10B) on the at least one organic functional layer (15).

9. Device according to the previous claim,
- wherein the radiation out-coupling material (20) is arranged in a layer-wise manner on at least one of the first (10A) and second (10B) electrodes.

10. Device according to one of the previous claims,
- wherein the substrate (5) is substantially transparent for the emitted radiation and the radiation out-coupling material is arranged on one of the main surface areas of the substrate (5).

11. Device according to one of the previous claims,
- wherein the inorganic nanoparticles (20C) are titanium dioxide particles.

12. Device according to one of the previous claims,
- wherein the substrate (5) is selected from a group consisting of the following materials:
- glass, metal, polymer and ceramic.

13. Device according to one of the previous claims,
- further comprising a cap (30) encapsulating the radiation emitting functional area (10A, 10B, 15).

14. Device according to the previous claim,
- wherein the cap (30) is substantially transparent for the emitted radiation and the radiation out-coupling material (20) is arranged between the radiation emitting functional area (10A, 10B, 15)and the cap.

15. Device according to one of the previous claims,
- wherein the radiation out-coupling material comprises a layer with an arrangement of at least a first (20A) and a second (20B) sub-layer, said sub-layers (20A, 20B) comprising different ratios of polysilsesquioxane and inorganic nanoparticles.

16. Device according to one of the previous claims,
- wherein the radiation out-coupling material comprises at least one lens (20E, 20F).

17. Method of manufacturing a radiation emitting electronic device (1) with the method steps:
A) Providing a substrate (5),
B) Producing a radiation emitting functional area (10A, 10B, 15) on the substrate,
C) Providing a radiation out-coupling material (20) comprising polysilsesquioxane (20D) and transparent inorganic nanoparticles (20C) in the optical path (100) of the functional area (10A, 10B, 15).

18. Method according to the previous claim,
- wherein in step C) the radiation out-coupling material (20) is formed by polymerizing a blend of silsesquioxane monomers and transparent inorganic nanoparticles (20C).

19. Method according to one of the claims 17 or 18,
- wherein in step C) at least a first (20A) an a second (20B) layer is formed using different ratios of silsesquioxane monomers and transparent inorganic nanoparticles for each layer.

20. Method according to anyone of the claims 17 to 19,
- wherein in step C) the radiation out-coupling material (20) is formed using wet deposition techniques.

21. Method according to anyone of the claims 17 to 20,
- wherein in step C) the radiation out-coupling material (20) is formed in the shape of at least one lens (20E, 20F).

22. Use of a material (20) comprising polysilsesquioxane (20D) and transparent inorganic nanoparticles (20C) for out-coupling radiation emitted from an optoelectronic device (1).

23. The device according to any of the claims 1 to 16,
- wherein the polysilsesquioxane is obtainable by reacting molecules of the following general formula: 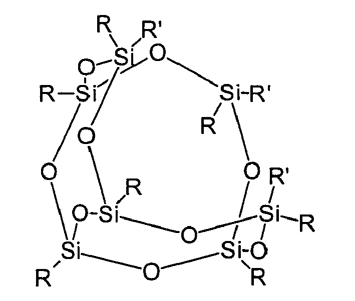 Wherein the substituent R is selected from:
- organic epoxides, hydrogen, alkyl-groups, and the substituent R' can be independently of each other a -O-Si (Alkyl)₂-Glycidoxy-alkyl-group or three R' groups can together form a bridging group so that a molecule of the following generals formula results: 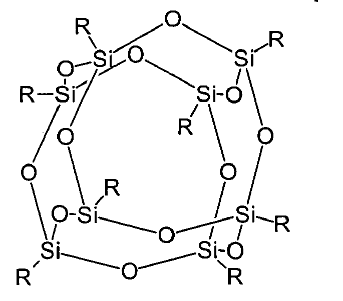 With R as defined above.

24. The device according to any of the claims 1 to 16 and 23, further comprising phosphors.

25. The device according to the previous claim, wherein the phosphors are included in the radiation out-coupling material.
